(19) Europäisches Patentamt / European Patent Office / Office européen des brevets

(11) **EP 3 051 391 B1**

(12) **EUROPEAN PATENT SPECIFICATION**

(45) Date of publication and mention
of the grant of the patent:
**29.04.2020   Bulletin 2020/18**

(21) Application number: **14848961.0**

(22) Date of filing: **21.07.2014**

(51) Int Cl.:
*G06F 3/041* (2006.01)          *B32B 33/00* (2006.01)
*B32B 37/00* (2006.01)          *B32B 38/00* (2006.01)
*G02F 1/33* (2006.01)           *B32B 37/24* (2006.01)
*G06F 3/044* (2006.01)          *G02F 1/1333* (2006.01)

(86) International application number:
**PCT/CN2014/082578**

(87) International publication number:
**WO 2015/043298 (02.04.2015 Gazette 2015/13)**

(54) **TOUCH PANEL**

BERÜHRUNGSTAFEL

PANNEAU TACTILE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **29.09.2013   CN 201310454870**
**04.06.2014   CN 201410243785**
**04.06.2014   CN 201410244190**

(43) Date of publication of application:
**03.08.2016   Bulletin 2016/31**

(73) Proprietor: **TPK Touch Solutions (Xiamen) Inc.**
**Fujian 361009 (CN)**

(72) Inventors:
• **LIN, Chingshan**
**Kaohsiung 804 (TW)**
• **WU, Chunyan**
**Sanming**
**Fujian 365116 (CN)**

• **JI, Lianjie**
**Xiamen**
**Fujian 361004 (CN)**
• **FANG, Fang**
**Xiamen**
**Fujian 361015 (CN)**

(74) Representative: **Goddar, Heinz J.**
**Boehmert & Boehmert**
**Anwaltspartnerschaft mbB**
**Pettenkoferstrasse 22**
**80336 München (DE)**

(56) References cited:
**WO-A1-2012/053731      WO-A1-2013/047699**
**WO-A2-2010/030137      CN-U- 202 815 764**
**CN-U- 203 102 217       CN-U- 203 178 950**
**CN-U- 203 465 692       CN-U- 203 502 934**
**JP-A- 2012 226 688      TW-A- 201 133 310**
**US-A1- 2013 147 727**

**Description**

**BACKGROUND OF THE DISCLOSURE**

Field of Invention

The present disclosure relates to touch sensing technology, and in particular to a touch panel.

Description of Related Art

On the current consumer electronics market, touch panels have been applied to various electronic products, such as smart phones, mobile phones, tablet computers and notebook computers. Since users can perform operations and give instructions directly through images displayed on a screen, the touch panels provide user-friendly operation interfaces between users and electronic products.

However, along with the ever-increasing requirements for lightness and thinness in structure of the touch panels and low cost in manufacturing process, there is still a need of further improvement to currently existing touch panel structures and manufacturing processes.

Document US 2013/147727 A1 discloses a touchscreen integrated organic light-emitting display device comprising, from bottom to top, a film substrate, an adhesive layer, a first etch stop layer, a first buffer layer, a thin film transistor array, organic light emitting diodes connected to the thin film transistors of respective pixels, a passivation layer, a touch electrode layer, a second buffer layer, a second etch stop layer, and a polarizing plate. Touchpad electrodes are located at the edge of the touch electrode layer, and the touchpad electrodes and dummy metal are formed at corresponding positions and connected by a sealant including conductive metal balls.

**SUMMARY**

The embodiment of the present invention provides a touch panel according to claim 1, that is lighter and thinner in structure and lower in cost in manufacturing process. Preferable embodiments are defined in the dependent claims.

Embodiments of the present disclosure provide a touch panel including a cover plate, a thin film layer, a buffer layer, a sensing layer and a bonding layer. The bonding layer is located between the cover plate and the thin film layer. The thin film layer is located between the bonding layer and the buffer layer. The buffer layer is located between the sensing layer and the thin film layer.

The present disclosure provides a touch panel. During the method of manufacturing the touch panel, two substrates, namely the first substrate and the second substrate, are introduced into the touch panel manufacturing process. In some embodiments, though the two substrates do not constitute parts of the final touch panel, the two substrates play a great role in the touch panel manufacturing process. By the supporting ability of the first substrate, the sensing layer is formed on the thin film layer, and then the first substrate is removed; and subsequently by the transferring ability of the second substrate, the thin film layer and the sensing layer formed thereon are adhered to the cover plate. Therefore, the formed touch panel is lighter and thinner and lower in manufacturing cost.

Additionally, in the touch panel structure provided by the embodiment of the present disclosure, the sensing layer is located on the other side of the thin film layer adhering to the cover plate, thereby preventing the adhering flatness between the thin film layer and the cover plate from being affected during the subsequent bonding between the sensing layer and a flexible printed circuit.

Moreover, the buffer layer is formed between the thin film layer and the sensing layer. By the characteristics of the buffer layer, the characteristic differences between the thin film layer and the sensing layer, such as the difference of refractive index and the difference of coefficient of thermal expansion, between the thin film layer and the sensing layer, can be reduced. Furthermore, due to existence of the buffer layer, the erosion to the thin film layer in the process of forming the sensing layer can be reduced, and the damage to the thin film layer and the sensing layer caused by stress during the removal of the first substrate can be further reduced.

**BRIEF DESCRIPTION OF THE DRAWINGS**

Figs. 1A-1H are schematic views of different steps of a touch panel manufacturing method according to some examples of the present disclosure;

Figs. 2A-2B are schematic views of different steps of a touch panel manufacturing method according to some embodiments of the present disclosure;

Figs. 3A-3D are schematic views of different steps of a touch panel manufacturing method according to some embodiments of the present disclosure; and

Fig. 4 is a structural schematic view of a sensing layer of a touch panel according to some embodiments of the present disclosure.

Reference numbers in the drawings:

10, 20 ~ touch panel;

30 ~ film element ;

100, 300 ~ first substrate;

200 ~ protective layer;

110 ~ first adhesive layer;

120 ~ loading layer;

121 ~ thin film layer;

122 ~ buffer layer;

130 ~ sensing layer ;

131 ~ first electrode blocks;

132 ~ first wires;

133 ~ second electrode blocks;

134 ~ second wires;

135 ~ insulating blocks;

136 ~ signal lines;

140 ~ second adhesive layer ;

150 ~ second substrate;

160 ~ bonding layer;

170 ~ cover plate ;

180 ~ mask layer ;

310 ~ third substrate;

M~ central region ;

N~ peripheral region ;

V~ regions;

CC' ~ cutting line;

A, B ~ surface.

**DETAILED DESCRIPTION**

The present disclosure is described in detail in the following examples in connection with the accompanying drawings.

Repeated component symbols may be used in different embodiments of the disclosure, which does not represent that there is any relevance between the different embodiments or drawings. Additionally, the case that one component is formed "above" or "below" another component may include some embodiments in which the two components are in direct contact, or some embodiments in which other additional components are sandwiched between the two components. Various components can be displayed in any scale so as to make the drawings be clear and concise.

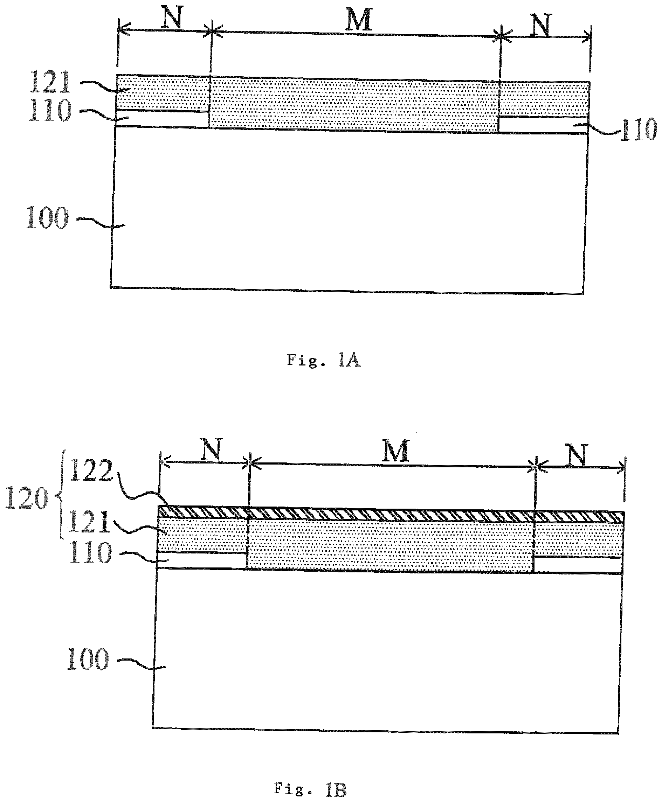

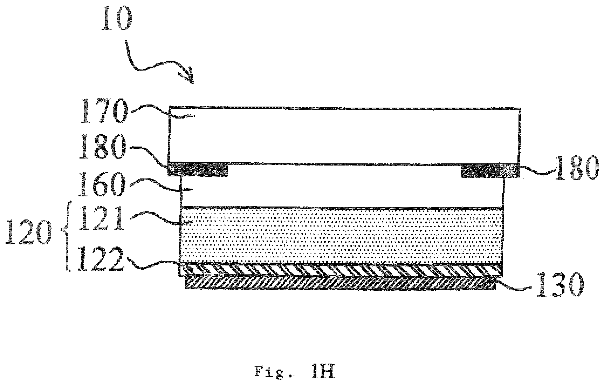

Figs. 1A-1H are schematic views of different steps of a touch panel manufacturing method according to some illustrative examples. Herein, Fig. 1H is a structural schematic view of a touch panel formed by a manufacturing method according to some illustrative examples.

Referring to Fig. 1A, at first, a first substrate 100 is provided, and a thin film layer 121 is formed on the first substrate 100. The first substrate 100 can serve as a mechanical support for a structure formed in a subsequent step, and the first substrate 100 can be a transparent or opaque substrate, such as a glass substrate. Since the first substrate 100 does not form a part of a finally formed touch panel product, the first substrate 100 can be made of a material relatively low in cost, as long as the first substrate 100 can provide necessary mechanical support. For example, the first substrate 100 can be made of a simple raw glass rather than chemically strengthened glass, so as to reduce the manufacturing cost of the touch panel. Additionally, after subsequently being removed from the touch panel, the first substrate 100 can be reused, so that the manufacturing cost is further reduced. It should be noted that the material of the first substrate 100 is not limited to glass, and may be made of any other appropriate material capable of providing mechanical support.

The thin film layer 121 may be of a single-layer or multi-layer structure or a stacked structure formed by a lower layer material having a separation ability and an upper layer material having no separation ability. The separation as used herein and hereinafter refers to removing the first substrate (or the second substrate) from other layers (such as the thin film layer 121) originally adhering to the first substrate (or the second substrate). Compared with conventional glass, the thin film layer 121 can be made of an organic material, such as polyimide (PI). Moreover, the thin film layer 121 can be made of polypropylene (PP), polystyrene (PS), acrylonitrile-butadiene-styrene (ABS), polyethylene terephthalate (PET), polyvinyl chloride (PVC), polycarbonate (PC), polyethylene (PE), polymethylmethacrylate (PMMA), polytetrafluoroethylene (PTFE) and cycloolefin copolymers (COP and Arton), or the combinations thereof.

The thin film layer 121 can be formed on the first substrate 100 by coating with a solution and thermal baking thereafter. For example, the thin film layer 121 made of polyimide is taken as an example for illustration. The first substrate 100 is placed on a movable platform, coated with a solution at a certain proportion by a coating cutter head or a coating machine, and then thermal-baked, so that portion of the solvent is volatilized and/or portion of components in the solution (such as polymeric monomers or precursors) are polymerized, and thus a polyimide thin film is formed. Herein, the thickness of the formed polyimide thin film can be adjusted by pressure, adjusting the solution to an appropriate viscosity, adjusting the flow speed of the solution, and controlling the moving speed of the platform. The thermal baking may include multiple times of baking at different temperatures, such as pre-baking and re-baking, and may also be a continuous baking process at a graded temperature. The aforesaid solution includes soluble polyimide (SPI) and an organic solvent, or includes a polyamide acid (PAA) and an organic solvent, wherein the PAA is a precursor of polyimide, and the organic solvent includes dimethylacetamide (DMAC), N-methyl pyrrolidone (NMP), ethylene glycol monobutyl ether (BC) and R-butyrolactone (GBL) and the like. The method of forming the thin film layer 121 is not limited thereto. For example, the thin film layer 121 may also be formed by a vapor deposition method or other appropriate methods. In other examples, a polyimide dry film may be directly laminated on the first substrate 100.

The thin film layer 121 formed by the polyimide can be modified by methods such as modification of composition and structure, copolymerization and blending, so as to yield a polyimide thin film with more excellent performance. For example, by changing the molecular chain length and/or a functional group of polyimide and/or by changing the surface microstructure of polyimide in a physical method, the thin film layer 121 formed by polyimide has low water absorptivity because high water absorptivity may affect the performance of the thin film layer 121 or the visual appearance of the finally formed touch panel. Generally, when the molecular chain is longer, the water absorptivity is higher. Polyimides of different molecular chain lengths show different viscosities, and the viscosity of polyimide can be changed according to specific needs. Polyimide can also have low water absorptivity by changing functional groups. For example, by changing halogen functional groups of polyimide, polyimide has fluorine-containing functional groups. Moreover, fluorine-containing polyimide can filter out light with short wavelengths. For example, the fluorine-containing polyimide can absorb ultraviolet light (the wavelength is 10-400 nm), thereby preventing the ultraviolet light from going through the thin film layer 121 and damaging the sensing layer formed in a subsequent step. In addition, the chromaticity of the touch panel can be improved, thereby preventing the touch panel from being unduly blue or unduly purple. The thin film layer 121 formed by polyimide has high transparency, high temperature resistance and low water absorptivity. Due to the high temperature resistance characteristic of the thin film layer 121, the thin film layer 121 can adapt to the temperature influenced during the forming of the sensing layer in a subsequent step; and the low water absorptivity prevents the thin film layer 121 from expanding due to water absorption during the subsequent process of forming the sensing layer, so as to prevent an electrode pattern of the sensing layer from being stereoscopic and visible, which would affect appearance of the touch panel. Furthermore, due to the low water absorptivity, the service life of the touch panel can be prolonged.

The thin film layer 121 has a thinner thickness than polyethylene terephthalate (PET). The thickness of the thin film layer 121 can be about 0.1-15 microns and is preferably about 2-5 microns, and the present disclosure is not limited to this. The thickness of the thin film layer 121 is thinner than that of an ordinary glass substrate, and the thin film layer 121 within this thickness range has good mechanical properties including ductility, toughness and thermal stability. The thin film layer 121 further has good optical characteristics, such as a high transmittance. By the lighter and thinner thin film layer in the present disclosure, the thickness and weight of the touch panel can be greatly reduced, and good optical characteristics and product appearance can still be maintained.

In some examples, the thin film layer 121 can be adhered to the first substrate 100 through a first adhesive layer 110. Generally, the adhesive force between the first substrate 100 (such as glass) and the thin film layer 121 (such as an organic polymer) is weak, and the first substrate 100 and the thin film layer 121 cannot be adhered tightly. In order to improve the adhesive force between the first substrate 100 and the thin film layer 121, the first adhesive layer 110 is arranged between the first substrate 100 and the thin film layer 121.

The first adhesive layer 110 is an adhesion promoter comprising both pro-orfanic functional groups and pro-inorganic functional groups, and can be formed on the first substrate 100 by curing after solution coating. When the first substrate 100 is made of inorganic materials such as glass while the thin film layer 121 is made of organic materials such as polyimide, different functional groups contained in the first adhesive layer 110 can adapt to adhesion characteristics of two different materials, so that the thin film layer 121 is firmly fixed to the first substrate 100. For example, when the first adhesive layer 110 is cured by heating, the first adhesive layer 110 is crosslinked with the first substrate 100 and accordingly adheres to the first substrate 100 well; in the process of forming the thin film layer 121, the thin film layer 121 usually also needs to be baked by heating, so that the first adhesive layer 110 can also be crosslinked with the thin film layer 121, and thus the thin film layer 121 adheres to the first substrate 100 well.

Meanwhile, since the thin film layer 121 may be required to be removed from the first substrate 100 more easily, the first adhesive layer 110 can be arranged to be located around the first substrate 100. For example, the first adhesive layer 110 is located in a peripheral region N of the first substrate 100, so that a part of the thin film layer 121 in the peripheral region N adheres to the first substrate 100 well; and in a region (such as a central region M) of the thin film layer 121 outside the peripheral region N, the adhesiveness between the thin film layer 121 and the first substrate 100 is relatively low since there is no first adhesive layer 110. Therefore, while the first adhesive layer 110 is not yet removed, the thin film layer 121 can be tightly attached to the first substrate 100, and after the first adhesive layer 110 is removed, the first substrate 100 and the thin film layer 121 can be separated conveniently. A specific removing method is described in detail below.

In other examples, the first adhesive layer 110 can wholly cover the first substrate 100; that is, the first adhesive layer 110 is located between the first substrate 100 and the thin film layer 121. Under this design, the first adhesive layer 110 can be made of a material with a changeable adhesion characteristic; that is to say, in the manufacturing process, there is high adhesive force between the first adhesive layer 110 and the first substrate 100, and when the first substrate is required to be removed, the adhesiveness can be reduced by particular solution soaking or temperature treatment or the like, so as to benefit the removal of the first substrate 100 from the thin film layer 121.

Next, referring to Fig. 1B, the buffer layer 122 is formed on the thin film layer 121, and the thin film layer 121 is located between the first substrate 100 and the buffer layer 122. The buffer layer 122 can be made of transparent insulating materials. In some examples, the buffer layer 122 can be made of silicon oxide and can be formed by chemical vapor deposition (CVD), printing, photoetching or other appropriate methods. In other examples, the buffer layer 122 includes titanium dioxide $(TiO_2)$, silicon dioxide $(SiO_2)$, zirconium dioxide $(ZrO_2)$, tantalum oxide, tungsten oxide, yttrium oxide, cerium oxide, antimony oxide, niobium oxide, boron trioxide, cerium fluoride, magnesium fluoride, calcium fluoride or the combinations of the foregoing. In a further example, the buffer layer 122 includes a composite material formed by organic materials and inorganic materials, wherein the inorganic materials include titanium dioxide $(TiO_2)$, silicon dioxide $(SiO_2)$, zirconium dioxide $(ZrO_2)$, tantalum oxide, tungsten oxide, yttrium oxide, cerium oxide, antimony oxide, niobium oxide, boron trioxide, aluminum oxide, zinc oxide, indium oxide, cerium fluoride, magnesium fluoride, calcium fluoride or the combinations of the foregoing. The aforesaid organic materials include high molecular polymers or resin, such as acrylic resin, polyimide (PI), polypropylene (PP), polystyrene (PS), acrylonitrile-butadiene-styrene (ABS), polyethylene terephthalate (PET), polyvinyl chloride (PVC), polycarbonate (PC), polyethylene (PE) and polymethylmethacrylate (PMMA) and the like.

Furthermore, in some examples, the aforesaid organic materials can co-exist with the inorganic materials. For example, in a hybrid material, the organic materials and the inorganic materials can be mixed at the nanometer level to form a novel molecular composite material. The inorganic materials can be mixed or combined with the organic materials by intermolecular acting force, such as Van der Waals force, hydrogen bonds, ionic bonds or covalent bonds. In other embodiments, an organic and inorganic mixture is formed by coating organic material particles with inorganic materials or embedding inorganic material particles in an organic layer.

The composite material formed by the organic materials and the inorganic materials has characteristics of the organic materials and characteristics of the inorganic materials, and by the characteristics, the composite material can meet various requirements for high performance. For example, the buffer layer 122 including the organic materials and the inorganic materials has a good adhering ability to both organic materials and inorganic materials, so that the buffer layer 122 can be suitable for different thin film layer materials.

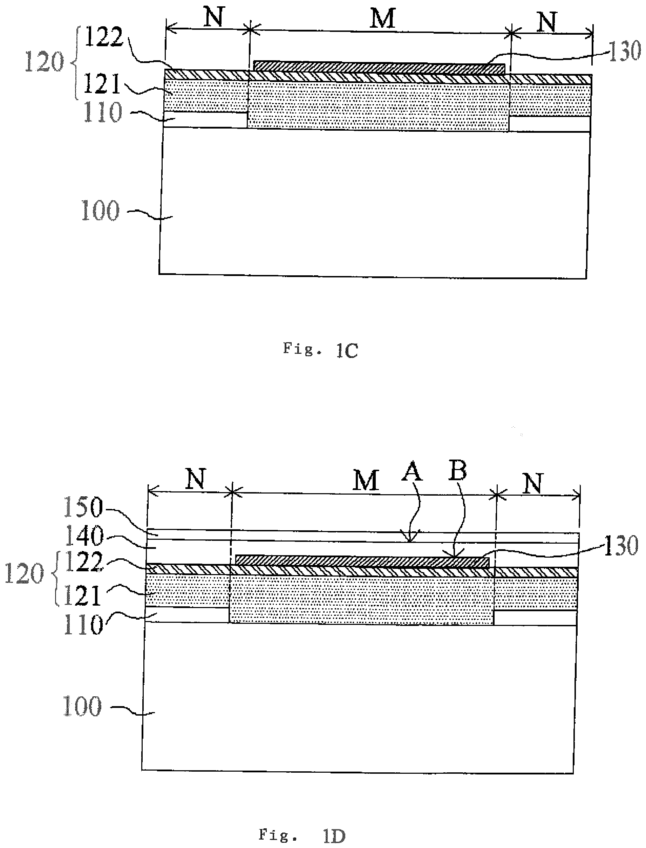

Next, referring to Figs. 1B and 1C, the sensing layer 130 is formed on the buffer layer 122 and located in the central region M of the first substrate 100. Compared with a buffer layer made of a single type of material, the buffer layer 122 made of the composite material can adapt to the requirements of the touch panel having different appearance demands by selecting materials with different refractive indexes. In detail, by adjusting the refractive index and thickness of the buffer layer 122, it is possible to make the refractive index of the buffer layer 122 match with the refractive index of an upper layer on the buffer layer 122 and the refractive index of a lower layer under the buffer layer 122. In this way, the transmittance of the touch panel can be improved, and the problem that the touch panel is poor in appearance is solved. For example, if the refractive index of the buffer layer 122 is $n_1$, the refractive index of the thin film layer 121 is $n_f$ and the refractive index of the sensing layer 130 is $n_T$, then $n_1$ should be greater than $n_f$, but smaller than $n_T$, i.e., $n_f < n_1 < n_T$, and preferably,

$$n_1 \approx \sqrt{n_f \times n_T}.$$

In this way, the optical properties, such as the refractive indexes of the thin film layer 121, the buffer layer 122 and the sensing layer 130 which are sequentially arranged are in an increasing order or a decreasing order. Therefore, light can go through the three layers smoothly, and the difference of light refractive indexes of a region with electrode blocks and a region without electrode blocks in the sensing layer 130 can be reduced, the visibility of an electrode pattern is lowered, and the visual appearance of the touch panel is improved.

In addition, the buffer layer 122 is also capable of functioning as a buffer to reduce the mechanical stress generated between the thin film layer 121 and the buffer layer 122 and between the sensing layer 130 and the buffer layer 122 respectively. This is particularly important in certain situations, such as during significant temperature increase or decrease, or peeling the glass substrate 100 off. As described above, the thin film layer 121 can be made of organic materials, such as polyimide (PI).

On the other hand, the sensing layer 130 is usually made of inorganic materials. In this regard, the thin film layer 121 formed by polyimide has a relatively high coefficient of thermal expansion (CTE) while the sensing layer 130 has a relatively low coefficient of thermal expansion. Besides, the thin film layer 121 formed by polyimide and the sensing layer 130 also differ greatly in mechanical properties. Therefore, high stress is generated between the thin film layer 121 and the sensing layer 130, and the stress not only induces an adverse effect (for example, the aforesaid electrode pattern is visible) on the visual appearance of the touch panel, but also may cause damage to the thin film layer 121 during the removal of the first substrate 100. The buffer layer 122 is added between the thin film layer 121 and the sensing layer 130, and through the buffering ability of the buffer layer 122, the stress possibly generated between the thin film layer 121 and the sensing layer 130 is effectively reduced. In this way, the quality of the touch panel can be improved greatly by adding the buffer layer 122 between the thin film layer 121 and the sensing layer 130.

Based on the above, the coefficient of thermal expansion of the buffer layer 122 is in a range between the coefficient of thermal expansion of the thin film layer 121 and the coefficient of thermal expansion of the sensing layer 130. For example, if the coefficient of thermal expansion of the thin film layer 121 made of polyimide is 1000 while the coefficient of thermal expansion of the sensing layer 130 is a single-digit value the coefficient of thermal expansion of the buffer layer 122 is preferably a three-digit value, and is not unduly close to the coefficient of thermal expansion of the sensing layer 130. For example, the range of the coefficient of thermal expansion of the buffer layer 122 is greater than 100; meanwhile, the coefficient of thermal expansion of the buffer layer 122 is not unduly close to that of the thin film layer 121. For example, the coefficient of thermal expansion of the buffer layer 122 is less than 900. Therefore, the coefficient of thermal expansion of the buffer layer 122 is close to the median of the coefficient of thermal expansion of the thin film layer 121 and the coefficient of thermal expansion of the sensing layer 130. That is another reason why the buffer layer 122 is formed by the organic materials and the inorganic materials, and the coefficient of thermal expansion of the buffer layer 122 can be adjusted conveniently.

In addition, the thickness of the buffer layer 122 is usually within a range between about 1 nanometer (10 angstroms) and about 300 nanometers (3000 angstroms) The buffer layer 122 can be formed by printing, coating or photoetching. For example, the buffer layer 122 can be formed by a convex board such as an Asahikasei photosensitive resin (APR) plate in a manner of transfer print. The buffer layer 122 formed in the manner of transfer print can reduce the stress between the sensing layer formed in a subsequent step and the thin film layer 121, thereby reducing deformation and the like of the sensing layer due to stress effect. In some examples, the buffer layer 122 is formed on the thin film layer 121 by solution coating, ultraviolet curing, heating and further curing.

The buffer layer 122 and the thin film layer 121 cooperatively form a loading layer 120 located on the first substrate 100. The buffer layer 122 has high hardness relative to the thin film layer 121. The loading layer 120 formed by the buffer layer 122 having high hardness and the thin film layer 121 having good ductility can simultaneously have good separation ability and good loading ability and can improve reliability of other elements formed on the loading layer 120 in subsequent steps. Compared with a buffer layer 122 made of a single material (such as silicon dioxide), the aforesaid buffer layer 122 made of the composite material benefits to adjust the stress thereof, and thus the stability of the whole touch structure during separation is improved.

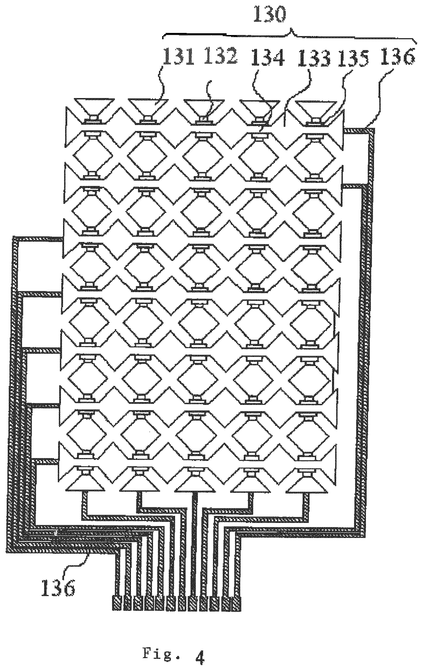

Next, referring to Figs. 1C and 4, Fig. 4 is a structural schematic view of a sensing layer of a touch panel according to some examples. The sensing layer 130 includes multiple first electrode blocks 131 arranged along a first direction, multiple first wires 132 for connecting adjacent first electrode blocks 131 along the first direction and multiple second electrode blocks 133 arranged along a second direction. All the second electrode blocks 133 are distributed on the two sides of the first wires 132, and insulating blocks 135 are formed on all the first wires 132 respectively. Second wires 134 for connecting adjacent second electrode blocks 133 along the second direction are formed on the insulating blocks 135. That is, the insulating blocks 135 are located between the first wires 132 and the second wires 134 so that the first wires 132 and the second wires 134 are electrically insulated from each other. Herein, the first direction is different from the second direction, and the first direction and the second direction are perpendicular to each other. The structure of the sensing layer 130 is not limited to the structure as shown in Fig. 4. For example, the sensing layer 130 can be of a comb-shaped, cross-shaped or wavy single-layer electrode structure; or in other embodiments, the sensing layer 130 can be a multilayer structure. For example, an electrode along the first direction, an electrode along the second direction and an insulating layer located between the first electrode and the second electrode are located on three independent layers respectively.

The specific steps of forming the sensing layer 130 can include the steps of first forming the first wires 132 on the buffer layer 122, then forming the insulating blocks 135 on all the first wires 132, and finally forming the first electrode blocks 131, the second electrode blocks 133 and the second wires 134. Or in another example, the first electrode blocks 131, the second electrode blocks 133 and the first wires 132 can be formed first, then the insulating blocks 135 are formed on all the first wires 132, and finally the second wires 134 are formed on the insulating blocks 135.

In addition, the steps of forming the sensing layer 130 further include the step that multiple signal lines 136 are formed. The first electrode blocks 131 located in the same axial direction are electrically connected with each other through the first wires 132 to form a sensing electrode array and then are electrically connected with the corresponding signal line 136. The second electrode blocks 133 located in the same axial direction are electrically connected with each other through the second wires 134 to form a sensing electrode array and then are electrically connected with the corresponding signal line 136. Sensing signals generated by the first electrode blocks 131 and the second electrode blocks 133 are transmitted to a controller (not shown in the figure) through the signal lines 136, and the controller can perform calculation according to the sensing signals to obtain the touch position. An arrangement manner and number of the signal lines 136 can be adjusted according to structures of different sensing layers 130, and are not limited to the form in Fig. 4. In detail, there can be multiple areas for collecting the signal lines 136, and one sensing electrode array can also be connected with two of the signal lines 136 arranged on opposite sides of the sensing electrode array.

The first electrode blocks 131 and the second electrode blocks 133 are made of transparent conductive materials which include indium tin oxide (ITO), aluminum zinc oxide, zinc oxide, tin antimony oxide, tin dioxide, indium oxide or the combinations thereof. The first electrode blocks 131 and the second electrode blocks 133 can also be made of conductive materials such as nano-silver, carbon nanotubes or metal meshes. The first wires 132, the second wires 134 and the signal lines 136 can be made of transparent conductive materials the same as the aforesaid electrode blocks, and can also be made of non-transparent conductive materials, such as metals or alloys which include gold, silver, copper, molybdenum, aluminum or combinations thereof. The first electrode blocks 131, the second electrode blocks 133, the first wires 132 and the second wires 134 can be formed by steps of sputtering or photoetching, and can also be formed by screen printing and spray coating or the like.

For the touch panel in the present disclosure, in some example, the first electrode blocks 131, the second electrode blocks 133, the first wires 132 and the second wires 134 are made of indium tin oxide formed by sputtering on the conditions of low temperature, and the low temperature is in a range from about 20 degrees centigrade to 80 degrees centigrade. Compared with high-temperature sputtering, the indium tin oxide formed by low-temperature sputtering has lower integral stress and accordingly benefits the stability of the whole touch structure formed on the loading layer 120 during the subsequent removal of the first substrate 100. In detail, at first, the first wires 132 are formed by sputtering and photoetching on the conditions of low temperature. At this stage, the first wires 132 are made of non-crystalline indium tin oxide; then the first wires 132 are baked, so that the non-crystalline indium tin oxide is converted to crystalline indium tin oxide; next, the insulating blocks 135 are formed on the first wires 132; and then the first electrode blocks 131, the second electrode blocks 133 and the second wires 134 are formed by sputtering and photoetching on the conditions of low temperature, and at this stage, the first electrode blocks 131, the second electrode blocks 133 and the second wires 134 are all made of the non-crystalline indium tin oxide; and finally, the first electrode blocks 131, the second electrode blocks 133 and the second wires 134 are baked, so that the non-crystalline indium tin oxide is converted to the crystalline indium tin oxide. The aforesaid baking temperature is greater than or equal to 180 degrees centigrade and less than or equal to 350 degrees centigrade, and is greater than or equal to 220 degrees centigrade and less than or equal to 240 degrees centigrade.

By baking the first wires 132, the problem that etchant used during the forming of the first electrode blocks 131, the second electrode blocks 133 and the second wires 134 erodes the formed first wires 132 is prevented. Besides, the transmittance of the first wires 132 can be improved, the impedance of the first wires 132 is reduced, and the conductivity of the first wires 132 is improved. Similarly, by baking the first electrode blocks 131, the second electrode blocks 133 and the second wires 134, the transmittance of the first electrode blocks 131, the second electrode blocks 133 and the second wires 134 can also be improved, the impedance of the first wires 132 is reduced, and the conductivity of the first wires 132 is improved.

In other examples, the first electrode blocks 131, the second electrode blocks 133 and the second wires 134 can be formed by sputtering and photoetching on the conditions of low temperature, and at this stage, the first electrode blocks 131, the second electrode blocks 133 and the first wires 132 are made of non-crystalline indium tin oxide; then, the first electrode blocks 131, the second electrode blocks 133 and the first wires 132 are baked, so that the non-crystalline indium tin oxide is converted to crystalline indium tin oxide; next, the insulating blocks 135 are formed on the first wires 132; the second wires 134 are formed, and at this stage, the second wires 134 are made of non-crystalline indium tin oxide; and finally the second wires 134 are baked, so that the non-crystalline indium tin oxide is converted to the crystalline indium tin oxide. In this example, the indium tin oxide is taken only as an example for description, and the present disclosure is not limited to this.

Next, referring to Fig. 1D, the second substrate 150 is formed on the sensing layer 130 and is able to cover the buffer layer 122 partially or even entirely. The second substrate 150 is adhered to the sensing layer 130 and the buffer layer 122 by a second adhesive layer 140. Materials of the second substrate 150 include, for example, polymers of polyethylene terephthalate (PET) or any appropriate material, such as glass, cycloolefin copolymers (COP and Arton) and propene polymer (PP), that is able to support a film element, so that the film element can be transferred to a cover plate according to an example of the present disclosure. The second adhesive layer 140 can be a removable adhesive and may include water insoluble glue or any other appropriate material that can adhere two layers temporarily and can be dissolved in subsequent steps or removed by other processes. In some examples, the second substrate 150 and the second adhesive layer 140 are laminated and can be, for example, a single-sided adhesive tape. The second substrate 150 is, for example, a flexible film, and the second adhesive layer 140 is an adhesive layer. As shown in Fig. 1D, the second adhesive layer 140 has a surface A and a surface B opposite to each other, and the surface proximal to the second substrate 150 is the surface A. The viscosity of the surface B of the second adhesive layer 140 can be reduced or even eliminated by light treatment such as ultraviolet irradiation, heat treatment or cold treatment or the combinations of the foregoing. Meanwhile, the surface A of the second adhesive layer 140 still has good viscosity with the second substrate 150, and thus the second adhesive layer 140 can be removed during the subsequent step of removing the second substrate 150.

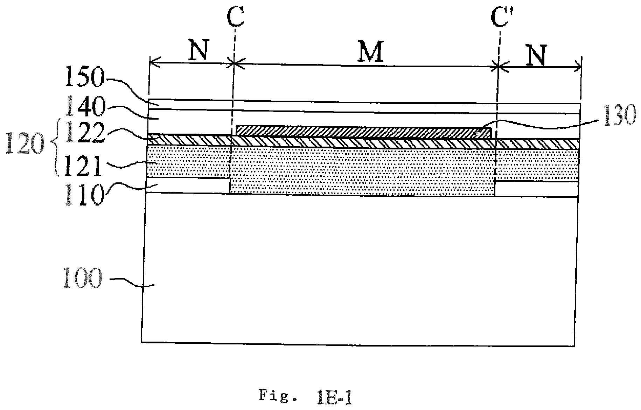

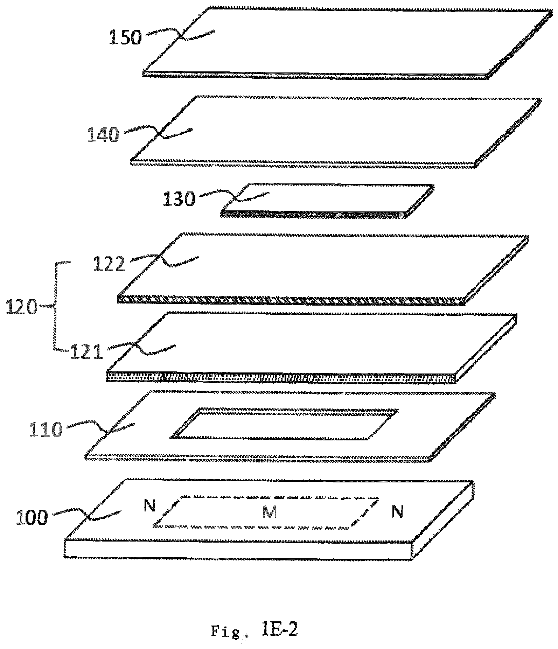

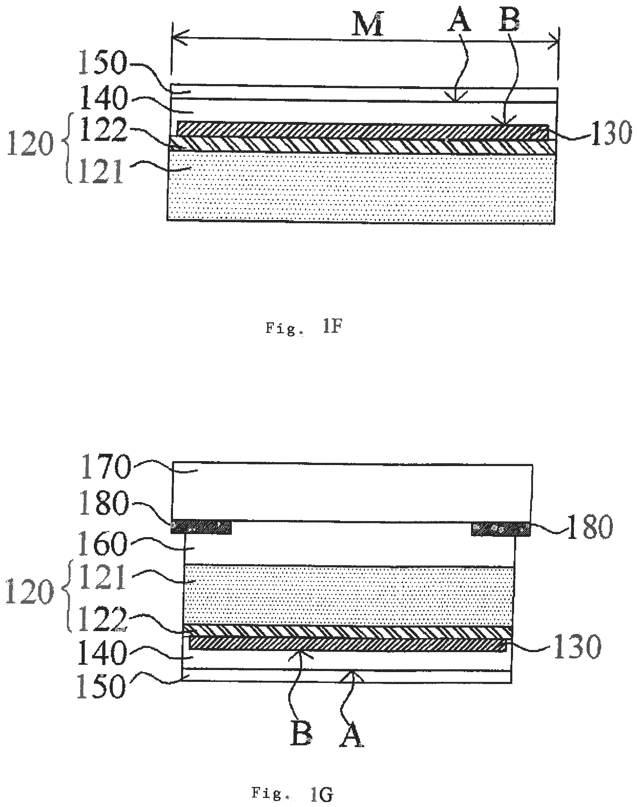

Next, referring to Figs. 1E-1, 1E-2 and 1F, herein, Fig. 1E-2 is an exploded view of Fig. 1E-1, showing the first substrate 100 removed from the thin film layer 121. As shown in Figs. 1E-1 and 1E-2, cutting can be performed along the edge of the peripheral region N proximal to the central region M, i.e., along a cutting line CC' as shown in Fig. 1E-1, so that the first adhesive layer 110, the thin film layer 121, the buffer layer 122, the second adhesive layer 140 and the second substrate 150 are cut off, and then the first substrate 100 is removed from the thin film layer 121. Since the first adhesive layer 110 playing a main adhesion role is cut off, no adhesive layer is between the first substrate 100 and the thin film layer 121, and the adhesive force between the first substrate 100 and the thin film layer 121 is significantly reduced. The first substrate 100 is then removed, and the influence of stress on the thin film layer 121 and other structures formed on the thin film layer 121 can be reduced in the process of removing the first substrate 100. In addition, when the first adhesive layer 110 is removed, cutting parameters can be controlled, so that the first substrate 100 is not cut. As such, the first substrate 100 can be reused, thereby reducing the cost.

In other examples, the cutting can be performed along the peripheral region N proximal to the edge of the central region M and can also be performed along a cutting line CC' as shown in Fig. 1E-1. What is different from the foregoing is that not only the first adhesive layer 110, the thin film layer 121, the buffer layer 122, the second adhesive layer 140 and the second substrate 150 which are located in the peripheral region N are removed, but also a part of the first substrate 100 located in the peripheral region N is removed, and then the cut first substrate 100 is removed. Or in a further example, between the step of forming the sensing layer 130 and the step of forming the second substrate 150, the cutting can be performed along the peripheral region N proximal to the edge of the central region M, so that the first adhesive layer 110, the thin film layer 121 and the buffer layer 122 which are located in the peripheral region N are removed; meanwhile, the first substrate 100 remains and is removed after the second substrate 150 is formed.

It needs to be noted that during the removing of the first substrate 100, assistance or other methods can be taken to facilitate separation. For example, the first substrate 100 can be removed from the thin film layer 121 by solution soaking, heat treatment, cold treatment, external force stripping or combinations of the foregoing. A solution used can be water, alcohol, propylene glycol methyl ether acetate (PGMEA) solution and N-methyl pyrrolidone (NMP) solution of polyvinylidene fluoride (PVDF) or the like. The heat treatment and cold treatment refer to heating or cooling of the first substrate 100, and stress is generated by the difference of coefficients of thermal expansion of the loading layer 120 and the first substrate 100, so as to facilitate separation.

Next, referring to Fig. 1G, a cover plate 170 is adhered to the thin film layer 121. The cover plate 170 and the thin film layer 121 can be adhered by a bonding layer 160 by lamination or other means. The bonding layer 160 is located between the thin film layer 121 and the cover plate 170. As shown in Fig. 1G, the cover plate 170, the bonding layer 160, the thin film layer 121, the buffer layer 122, the sensing layer 130, the second adhesive layer 140 and the second substrate 150 are stacked in that order from top to bottom.

The cover plate 170 is able to protect the structures below it and can be made of transparent materials such as glass, polyimide (PI), polypropylene (PP), polystyrene (PS), acrylonitrile-butadiene-styrene (ABS), polyethylene terephthalate (PET), polyvinyl chloride (PVC), polycarbonate (PC), polyethylene (PE), polymethylmethacrylate (PMMA), polytetrafluoroethylene (PTFE) or the like. The cover plate 170 can include a hard material or a flexible material. In order to increase the strength of the cover plate 170, the six surfaces of the cover plate 170 may all be chemically strengthened, or two opposite surfaces of the cover plate 170 may be chemically strengthened and four lateral surfaces may be physically strengthened. The cover plate 170 can be formed by cutting a glass board into small pieces first which matches the size of one touch panel module and then chemically strengthening the above pieces. The cover plate 170 can include two planar surfaces (for example, the upper surface and the lower surface are planar surfaces), two curved surfaces (for example, the upper surface and the lower surface are curved surfaces) or one planar surface and one curved surface (for example, one of the upper surface and the lower surface is a planar surface and another is a curved surface). For example, the cover plate 170 can be formed in a 2.5D shape or a 3D shape. The upper surface of the cover plate 170, which is opposite to the thin film layer 121, can serve as a contact surface for being in touch with an object. The bonding layer 160 can be made of solid or liquid optical adhesive or other appropriate transparent bonding materials.

The loading layer 120 and the sensing layer 130 of the present disclosure can be referred to as a film element. Compared with an ordinary touch module which includes a glass substrate and a thin film layer, or two thin film layers, or two glass substrates serving as loading plates and then combined with corresponding sensing layers, the film element of the present disclosure is thinner and more flexible and can serve as a touch element to adhere to hard substrates with different curvature radius or adhere to a flexible substrate. Thus, the film element can adapt to the design requirements of different touch panels more flexibly. In addition, by the transferring ability of the second substrate 150, the thin film layer 121 together with the buffer layer 122 and the sensing layer 130 are adhered to the cover plate 170. The second substrate 150 is made of a flexible material while the cover plate 170 is made of a relatively hard material, such as toughened glass, so that the flexible material can be adhered to the hard material more easily, and the bonding layer 160 can be prevented from generating bubbles, and the thickness of the bonding layer 160 can be reduced.

A mask layer 180 can be formed on the cover plate 170, and the mask layer 180 is located on at least one side of the cover plate 170 and used for shielding signal lines (such as signal lines 136 in Fig. 4), so that the signal lines cannot be easily seen by users from one side of the upper surface of the cover plate 170. In some examples, the mask layer 180 is located on the lower surface of the cover plate 170. That is, the mask layer 180 is located on one side of the cover plate 170 proximal to the thin film layer 121. In other examples, the mask layer 180 can be located on the upper surface of the cover plate 170. That is, the mask layer 180 is located on the other side of the cover plate 170 opposite to the thin film layer 121. In other examples, the mask layer 180 can further be a decorative film which includes a transparent film, and the mask layer is arranged on a peripheral region of the transparent film. The deco-film can be directly arranged on the upper surface of the cover plate, and can also be adopted to replace the cover plate 170 and the mask layer 180. The mask layer 180 can be made of colored ink, colored photoresist or the combination of the colored ink and the colored photoresist. The mask layer 180 can be a single layer structure or a composite laminated structure, wherein the single layer structure is, for example, a black ink layer; and the composite laminated structure is, for example, a stacked structure of an ink layer and a photoresist layer, a stacked structure of a white ink layer and a black ink layer, or a stacked structure of a white ink layer, a black ink layer and a photoresist layer or the like.

Finally, referring to Figs. 1G and 1H, the second substrate 150 and the second adhesive layer 140 are removed from the sensing layer 130. Specifically, the second adhesive layer 140 can undergo pretreatment in advance, such as light treatment, heat treatment or cold treatment or combinations thereof. For example, according to the differences of materials of the second adhesive layer 140, the adhesiveness between the second adhesive layer 140 and the sensing layer 130 can be reduced by ultraviolet irradiation, heating or cooling, and then the second adhesive layer 140 and the second substrate 150 are removed from the sensing layer 130. For example, as described above, the stacked structure of the second adhesive layer 140 and the second substrate 150 can be the single-sided adhesive, and by ultraviolet irradiation, the adhesiveness between the surface B of the second adhesive layer 140 and the sensing layer 130 is reduced or even eliminated; meanwhile, the adhesiveness between the surface A of the second adhesive layer 140 and the second substrate 150 remains, and thus the second substrate 150 and the second adhesive layer 140 can be removed simultaneously and conveniently. Of course, different removal methods can be selected according to the materials of the second adhesive layer 140, and the present disclosure is not limited thereto.

The touch panel 10 as shown in Fig. 1H is finally formed through the aforesaid steps, and the top of the figure is a touch and observation surface for a user. The touch panel 10 includes the cover plate 170, the bonding layer 160, the thin film layer 121, the buffer layer 122 and the sensing layer 130 which are stacked from top to bottom; that is to say, the bonding layer 160 is located between the cover plate 170 and the thin film layer 121; the thin film layer 121 is located between the bonding layer 160 and the buffer layer 122; and the buffer layer 122 is located between the thin film layer 121 and the sensing layer 130.

Further referring to Fig. 1H, the touch panel 10 further includes the mask layer 180, and the mask layer 180 is located on at least one side of the cover plate 170. The detailed structure and materials of each component and a manufacturing method thereof have been described above, and accordingly are no longer repeated herein. The touch panel can be applied to touch display devices such as a computer system, a mobile phone, a digital media player, a tablet computer, an ultrabook, a wearable touch device and a vehicle-mounted touch system.

After the steps shown in Fig. 1A-1H are finished, a flexible printed circuit with a controller can be further adhered to the signal lines 136 by the anisotropic conductive adhesive. Compared with direct adhesion of the flexible printed circuit after the step of Fig. 1C, in the present disclosure, the adhesion of the flexible printed circuit is performed after the step of Fig. 1H is finished, so as to prevent the problem of drop proneness of the flexible printed circuit that possibly occurs in the manufacturing process of removing the first substrate 100 or the second substrate 150, thereby improving the stability of the whole touch panel.

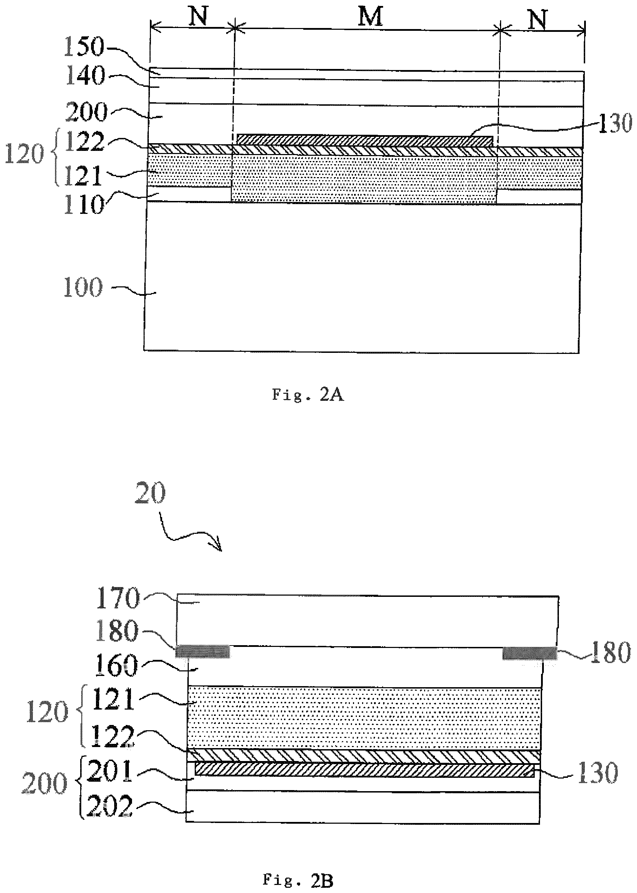

Figs. 2A-2B are schematic views of different steps of a touch panel manufacturing method according to another embodiment of the present disclosure. Fig. 2B further illustrates a structural schematic view of a touch panel according to some embodiments of the present disclosure. Fig. 2A illustrates the step following Fig. 1C. The steps prior to the step as shown in Fig. 2A are the same as those of Figs 1A-1C, and for simplicity, the steps are no longer repeated. As shown in Fig. 2A, after the forming of the sensing layer 130, the method further includes the step of forming a protective layer 200 above the sensing layer 130, and the sensing layer 130 is located between the protective layer 200 and the buffer layer 122. The protective layer 200 can protect the sensing layer 130, and the influence on the sensing layer 130 in the process of removing the second adhesive layer 140 and the second substrate 150 can be reduced. Besides, after the removal of the second adhesive layer 140 and the second substrate 150, the erosion or corrosion of the sensing layer 130 caused by air, water vapor or other substances in the environment is reduced. Furthermore, the protective layer 200 needs to expose the joint of the signal lines connected with the flexible printed circuit, so as to benefit the connection of the signal line and the flexible printed circuit.

Referring to Figs. 1D-1H, the steps following the step as shown in Fig. 2A are substantially similar to the steps of Figs. 1D-1H. The difference is that the second substrate 150 and the second adhesive layer 140 are formed above the protective layer 200. That is, the second adhesive layer 140 is located between the protective layer 200 and the second substrate 150. A touch panel 20 formed by removing the first substrate 100 and the first adhesive layer 110, adhering the first substrate 100 and the first adhesive layer 110 to the cover plate 170 and then removing the second substrate 150 and the second adhesive layer 140 further includes the protective layer 200. As shown in Fig. 2B, the touch panel 20 includes the cover plate 170, the bonding layer 160, the thin film layer 121, the buffer layer 122, the sensing layer 130 and the protective layer 200 which are stacked from top to bottom. Except for the protective layer 200, structures and materials of other components and manufacturing methods thereof are described as the above and accordingly are no longer repeated.

In addition, referring to Fig. 2B, the protective layer 200 can be a single-layer structure or a multi-layer structure. For example, when of the protective layer 200 is the multi-layer structure, the protective layer 200 may include a first protective layer 201 and a second protective layer 202, wherein the first protective layer 201 is located between the sensing layer 130 and the second protective layer 202, and a display device can be adhered to one side of the second protective layer 202 distal to the first protective layer 201, so as to form a touch display device cooperatively. The first protective layer 201 and the second protective layer 202 can be made of different materials to achieve different effects.

The first protective layer 201 can be selected from at least one of organic materials, inorganic materials, composite materials or high polymer materials. In some embodiments, the first protective layer 201 can be made of the same composite material as the aforesaid buffer layer 122. For example, the composite material includes titanium dioxide ($TiO_2$), silicon dioxide ($SiO_2$), zirconium dioxide ($ZrO_2$) or the combinations thereof, or a compound formed by titanium dioxide ($TiO_2$), silicon dioxide ($SiO_2$) and organic materials, or a compound formed by zirconium dioxide ($ZrO_2$), silicon dioxide ($SiO_2$) and organic materials. By adjusting the refractive index and thickness of the first protective layer 201, and by the buffer layer 122, the problem that touch panel is poor in appearance due to the light reflection differences between a region of the sensing layer 130 with an electrode block and a region of the sensing layer 130 without an electrode block is solved. For example, if the refractive index of the first protective layer 201 is $n_2$, the refractive index of the second protective layer 202 is $n_3$, and the refractive index of the sensing layer is $n_T$, $n_3 < n_2 < n_T$,

and preferably, $n_2 \approx \sqrt{n_3 \times n_T}$. In some embodiments, the thickness of the first protective layer 201 can be about 0.01 micron to 0.3 micron.

The aforesaid first protective layer 201 mainly plays a role of refractive index matching, the second protective layer 202 mainly protects the sensing layer 130 and reduces erosion or corrosion of to the sensing layer 130 caused by air, water vapor or other substances in the environment. Materials of the second protective layer 202 can include appropriate transparent insulating materials such as thermosetting resin, silicon dioxide and photoresist.

The first protective layer 201 and the second protective layer 202 can be formed by a convex board such as an Asahikasei photosensitive resin (APR) plate in a manner of transfer print. The first protective layer 201 and the second protective layer 202 which are formed by the transfer print can reduce the stress effect between the sensing layer 130 and the other layers and can improve stability of the sensing layer 130. Meanwhile, the second substrate and the second adhesive layer can be removed conveniently in subsequent steps, and the stress effect is reduced. In another embodiment, the first protective layer 201 and the second protective layer 202 can be formed respectively by solution coating, ultraviolet curing and heat curing and the like. In other embodiments of the present disclosure, the protective layer 200 can also be formed by processes such as sputtering, chemical vapor deposition (CVD), inkjet printing, slit coating, spin coating, spray coating or roller coating according to requirements.

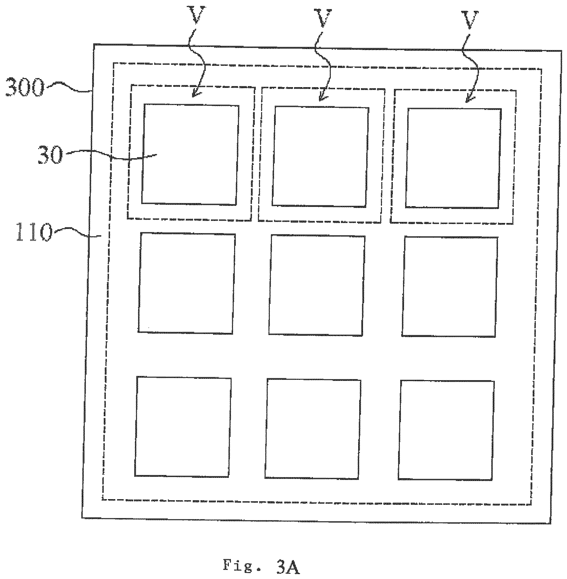

The aforesaid embodiments are described by taking independent forming of single touch panels as an example. To improve production efficiency and reduce cost, multiple film elements (each including a thin film layer, a buffer layer, a sensing layer, a protective layer, a second adhesive layer and a second substrate) can be formed on a large first substrate continuously. In a step prior to adhering the film elements to the cover plate, the multiple film elements are separated respectively, so that multiple touch panels can be formed in one process, the production efficiency is improved, and the cost is reduced. Specific manufacturing processes can be referred to corresponding embodiments of Figs. 3A-3D.

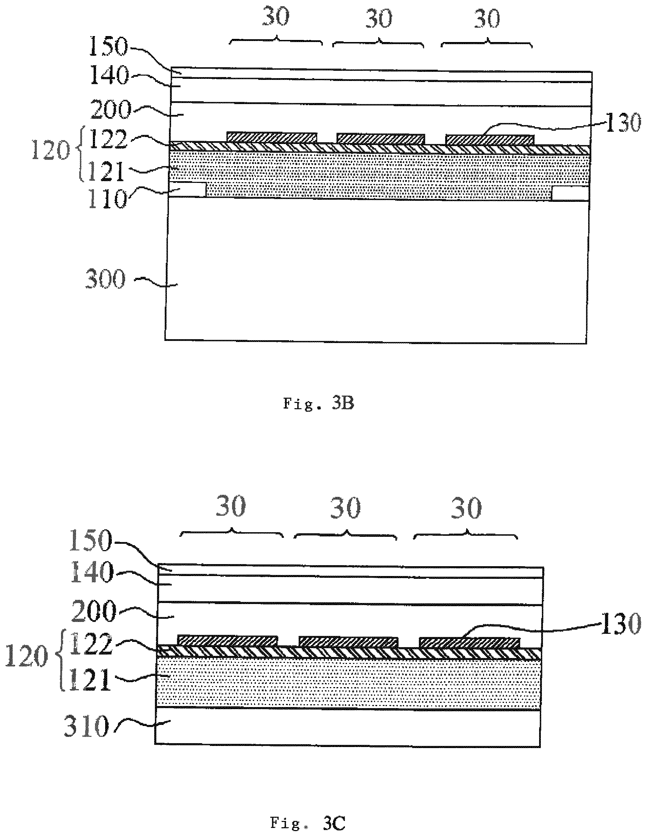

Figs. 3A-3D are schematic views of different steps of a touch panel manufacturing method according to a further embodiment of the present disclosure. Referring to Figs. 3A and 3B, herein, the Fig. 3B is a schematic cross-sectional view of Fig. 3A. Multiple regions V at intervals are predetermined or divided on a large first substrate 300, and the sizes of the regions V can be determined according to the size of the touch panel. Next, the first adhesive layer 110, the thin film layer 121 and the buffer layer 122 are sequentially formed on the first substrate 300, and multiple sensing layers 130 which are arranged at intervals with each other are simultaneously formed on the buffer layer 122 and correspond to the regions V; the protective layers 200 are formed on the sensing layers 130, and the second substrate 150 is formed on the protective layers 200 by utilizing the adhesion of the second adhesive layer 140. The multiple sensing layers 130 are arranged at intervals, and other structures such as the first substrate 300, the thin film layer 121, the buffer layer 122, the protective layers 200, the second adhesive layer 140 and the second substrate 150 are respectively integral structures. In addition, the methods of forming the first adhesive layer 110, the thin film layer 121, the buffer layer 122, the second adhesive layer 140 and the second substrate 150 can be understood from to the corresponding examples of the aforesaid Figs. 1A-1H, and the method of forming the protective layers 200 can be understood from to the corresponding embodiments of the aforesaid Figs. 2A and 2B.

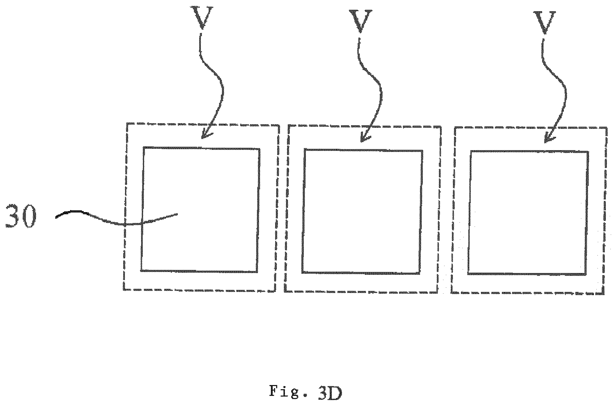

Next, referring to Figs. 3C and 3D, the first substrate 300 is removed, a film element 30 is adhered to a third substrate 310 by one side of the thin film layer 121. The thin film layer 121 is located between the buffer layer 122 and the third substrate 310. Herein, a method of removing the first substrate 300 is the same as a method in the aforesaid embodiment. The structure of the third substrate 310 can be similar to the structure of the aforesaid second substrate in combination with the second adhesive layer, and the structure of the third substrate 310 includes a flexible thin film layer and an adhesive layer, such as single-sided adhesive, wherein the flexible thin film layer and the adhesive layer are adhered to each other, and thus the surface with adhesiveness is adhered to the thin film layer 121 of the film element 30. The third substrate 310 can support and protect the film elements 30, and the damage to the film elements 30 in the subsequent separation process is avoided.

Then, the film elements 30 corresponding to the regions V are separated, and the film elements which are originally integrally connected are separated as multiple independent small film elements 30. The film elements 30 can be separated by cutting with knives or laser cutting. As shown in Fig. 3D, the separated small film elements with three pieces in one group are taken as an example in Fig. 3D, and it can be understood that the film elements can also be separated as smaller or larger film elements.

Then, the third substrate 310 is removed. Referring to Fig. 2B, the small film elements are respectively adhered to the cover plate 170, and finally the second substrate 150 and the second adhesive layer 140 are removed, so as to respectively form multiple touch panels. The finally formed touch panel structures are shown in Fig. 2B. The cover plate 170 of the embodiment can be formed by cutting a large glass substrate into the dimension conforming to a touch module and then performing chemical enhancement. Compared with a conventional method of performing chemical enhancement on a large glass cover plate, depositing multiple sensing layers and then cutting the large glass cover plate and the sensing layers to obtain small touch panels, the cover plate 170 of this embodiment is cut in advance and then strengthened and finally adhered to the film element without the need of further cutting. Therefore, the cover plate 170 has good edge strength. A process of forming the sensing layers does not affect the strength of the cover plate, and the strength of the whole finally formed touch panels can be improved.

In the process of adopting the large first substrate 300 to form multiple touch panels as shown in Figs. 3A-3D, the first adhesive layer for adhering the thin film layers to the first substrate 300 can be arranged in a peripheral region of the large substrate 300, for example, around the large substrate 300. In another embodiment, the first adhesive layer can be further arranged around each region V, so as to further enhance the adhesiveness between the thin film layers and the first substrate 300. Therefore, during the removal of the first substrate 300, the first adhesive layer located around the first substrate 300 and adhesive layers located around each region V are removed together; or the first adhesive layer is only arranged around each region V and is not arranged around the first substrate 300, and the present disclosure is not limited thereto.

According to the touch panel provided by the present disclosure and the manufacturing method thereof, the sensing layer is formed on the thin film layer by the supporting ability of the first substrate, and the thin film layer and the sensing layer formed on the thin film layer are adhered to the cover plate by the transfer ability of the second substrate. Therefore, the formed touch panel is lighter and thinner and low in manufacturing cost. In addition, the sensing layer is located on the other side of the thin film layer adhering to the cover plate, so that the problem that the adhering flatness between the thin film layer and the cover plate is affected during the connection of the sensing layer and the flexible printed circuit is solved. In addition, the buffer layer is formed between the thin film layer and the sensing layer, so that the erosion of the thin film layer in the process of forming the sensing layer can be reduced, and the damage to the thin film layer and the sensing layer caused by stress during the removal of the first substrate can be further reduced.

**Claims**

1. A touch panel (20), comprising:

   a cover plate (170);
   a bonding layer (160);
   a thin film layer (121), wherein the bonding layer (160) is located between the cover plate (170) and the thin film layer (121);
   a buffer layer (122) located on the thin film layer, and the thin film layer (121) is located between the bonding layer (160) and the buffer layer (122); and
   a sensing layer (130) located on the buffer layer (122), and the buffer layer (122) is located between the sensing layer (130) and the thin film layer (121), wherein said touch panel (20) further comprises a protective layer (200) on the sensing layer (130), and the sensing layer (130) is located between the buffer layer (122) and the protective layer (200), wherein said protective layer (200) is suitable for reducing erosion or corrosion of the sensing layer (130) caused by air, water vapor or other substances in the environment, and wherein a display device can be adhered to the protective layer so as to form a touch display device cooperatively.

2. The touch panel (20) of claim 1, wherein the protective layer (200) comprises a first protective layer (201) and a second protective layer (202), and the first protective layer (201) is located between the sensing layer (130) and the second protective layer (202).

3. The touch panel (20) of claim 1, wherein a thickness of the thin film layer (121) is in a range between 0.1 micron and 15 micron, preferably in a range between 2 micron and 5 micron.

4. The touch panel (20) of claim 1, wherein a material of the thin film layer (121) comprises polypropylene (PP), polystyrene (PS), acrylonitrile-butadiene-styrene (ABS), polyethylene terephthalate (PET), polyvinyl chloride (PVC), polycarbonate (PC), polyethylene (PE), polymethylmethacrylate (PMMA), polytetrafluoroethylene (PTFE) and cycloolefin copolymers (COP and Arton), or the combinations thereof.

5. The touch panel (20) of claim 1, wherein a refractive index of the buffer layer (122) is $n_1$, a refractive index of the sensing layer (130) is $n_T$, and a refractive index of the thin film layer is $n_f$, and wherein $n_f < n_1 < n_T$.

6. The touch panel (20) of claim 1, wherein a thickness of the buffer layer (122) is in a range between 1 nanometer (10 angstroms and about 300 nanometers (3000 angstroms)

7. The touch panel (20) of claim 1, wherein a material of the buffer layer (122) comprises an organic material and an inorganic material.

8. The touch panel (20) of claim 1, wherein a material of the buffer layer (122) comprises titanium dioxide ($TiO_2$), silicon dioxide ($SiO_2$), zirconium dioxide ($ZrO_2$) or combinations thereof, or a composite material formed by an organic material, titanium dioxide ($TiO_2$) and silicon dioxide ($SiO_2$), or a composite material formed by an organic material, zirconium dioxide ($ZrO_2$) and silicon dioxide ($SiO_2$).

9. The touch panel (20) of claim 2, wherein a refractive index of the first protective layer (201) is $n_2$, and a refractive index of the second protective layer (202) is $n_3$, and a refractive index of the sensing layer (130) is $n_T$, and wherein $n_3 < n_2 < n_T$.

10. The touch panel (20) of claim 2, wherein a material of the first protective layer (201) comprises an organic material and an inorganic material, and/or, wherein a material of the first protective layer (201) comprises titanium dioxide ($TiO_2$), silicon dioxide ($SiO_2$), zirconium dioxide ($ZrO_2$) or combinations thereof, or a composite material formed by an organic material, titanium dioxide ($TiO_2$) and silicon dioxide ($SiO_2$), or a composite material formed by an organic material, zirconium dioxide ($ZrO_2$) and silicon dioxide ($SiO_2$), and/or, wherein a material of the second protective layer (202) is a transparent resin, silicon dioxide or photoresist.

11. The touch panel (20) of claim 1, wherein the sensing layer (130) comprises a plurality of first electrode blocks (131) arranged along a first direction, a plurality of first wires (132) connecting the first electrode blocks (131) adjacent to each other, a plurality of second electrode blocks (133) arranged along a second direction, a plurality of second wires (134) connecting the second electrode blocks (133) adjacent to each other, and a plurality of insulating blocks (135) located between the first wires (132) and the second wires (134) to electrically insulate the first wires (132) and the second wires (134), wherein the second electrode blocks (133) are distributed on two sides of the first wires (132), wherein the touch panel (20) preferably further comprises:
a mask layer (180) located on at least one side of the cover plate (170), wherein the sensing layer (130) further comprises a plurality of signal lines (136) respectively electrically connected to the first electrode blocks (131) and the second electrode blocks (133), and the mask layer (180) is used for shielding the signal lines (136).

12. The touch panel (20) of claim 1, wherein a coefficient of thermal expansion of the buffer layer (122) is in a range between a coefficient of thermal expansion of the thin film layer (121) and a coefficient of thermal expansion of the sensing layer (130).

13. The touch panel (20) of claim 1, wherein the thin film layer (121) is formed on a first substrate (100) by curing after solution coating, wherein the solution preferably comprises soluble polyimide and organic solvents, or the solution comprises polyamic acid and organic solvents.

14. The touch panel (20) of claim 1, wherein the cover plate (170) is a toughened glass.

**Patentansprüche**

1. Touchpanel (20), das Folgendes umfasst:

eine Deckplatte (170);
eine Verbindungsschicht (160);
eine Dünnfilmschicht (121), wobei sich die Verbindungsschicht (160) zwischen der Deckplatte (170) und der Dünnfilmschicht (121) befindet;
eine Pufferschicht (122), die sich auf der Dünnfilmschicht befindet, wobei sich die Dünnfilmschicht (121) zwischen der Verbindungsschicht (160) und der Pufferschicht (122) befindet; und
eine Sensorschicht (130), die sich auf der Pufferschicht (122) befindet, wobei die Pufferschicht (122) sich zwischen der Sensorschicht (130) und der Dünnfilmschicht (121) befindet, wobei
das Touchpanel (20) ferner eine Schutzschicht (200) auf der Sensorschicht (130) umfasst und die Sensorschicht (130) sich zwischen der Pufferschicht (122) und der Schutzschicht (200) befindet, wobei die Schutzschicht (200) geeignet ist, die Erosion oder Korrosion der Sensorschicht (130), die durch Luft, Wasserdampf oder andere Substanzen in der Umgebung verursacht wird, zu reduzieren, und wobei eine Anzeigevorrichtung an der Schutzschicht befestigt werden kann, um so gemeinsam eine Touchanzeigevorrichtung zu bilden.

2. Touchpanel (20) nach Anspruch 1, wobei die Schutzschicht (200) eine erste Schutzschicht (201) und eine zweite Schutzschicht (202) umfasst und die erste Schutzschicht (201) zwischen der Sensorschicht (130) und der zweiten Schutzschicht (202) angeordnet ist.

3. Touchpanel (20) nach Anspruch 1, wobei eine Dicke der Dünnfilmschicht (121) in einem Bereich zwischen 0,1 $\mu$m und 15 $\mu$m, vorzugsweise in einem Bereich zwischen 2 $\mu$m und 5 $\mu$m, liegt.

4. Touchpanel (20) nach Anspruch 1, wobei ein Material der Dünnfilmschicht (121) Polypropylen (PP), Polystyrol (PS), Acrylnitril-Butadien-Styrol (ABS), Polyethylenterephthalat (PET), Polyvinylchlorid (PVC), Polycarbonat (PC), Polyethenylen (PE), Polymethylmethacrylat (PMMA), Polytetrafluorethylen (PTFE) und Cy-Cloolefin-Copolymere (COP und Arton) oder Kombinationen davon umfasst.

5. Touchpanel (20) nach Anspruch 1, wobei ein Brechungsindex der Pufferschicht (122) n1, ein Brechungsindex der Sensorschicht (130) nT und ein Brechungsindex der Dünnfilmschicht nf ist, und wobei nf < n1 < nT ist.

6. Touchpanel (20) nach Anspruch 1, wobei die Dicke der Pufferschicht (122) in einem Bereich zwischen 1 nm (10 Ängström) und etwa 300 nm (3000 Ängström) liegt.

7. Touchpanel (20) nach Anspruch 1, wobei ein Material der Pufferschicht (122) ein organisches Material und ein anorganisches Material umfasst.

8. Touchpanel (20) nach Anspruch 1, wobei ein Material der Pufferschicht (122) Titandioxid ($TiO_2$), Siliziumdioxid ($SiO_2$), Zirkoniumdioxid ($ZrO_2$) oder Kombinationen davon oder ein Verbundmaterial aus einem organischen Material, Titandioxid ($TiO_2$) und Siliziumdioxid ($SiO_2$) oder ein Verbundmaterial aus einem organischen Material, Zirkoniumdioxid ($ZrO_2$) und Siliziumdioxid ($SiO_2$) umfasst.

9. Touchpanel (20) nach Anspruch 2, wobei ein Brechungsindex der ersten Schutzschicht (201) n2 und ein Brechungsindex der zweiten Schutzschicht (202) n3 und ein Brechungsindex der Sensorschicht (130) nT ist, und wobei n3<n2<nT.

10. Touchpanel (20) nach Anspruch 2, wobei ein Material der ersten Schutzschicht (201) ein organisches Material und ein anorganisches Material umfasst, und/oder wobei ein Material der ersten Schutzschicht (201) Titandioxid ($TiO_2$), Siliziumdioxid ($SiO_2$), Zirkoniumdioxid ($ZrO_2$) oder Kombinationen davon umfasst, oder ein Verbundmaterial, das aus einem organischen Material, Titandioxid ($TiO_2$) und Siliziumdioxid ($SiO_2$) gebildet ist, oder ein Verbundmaterial, das aus einem organischen Material, Zir-

koniumdioxid (ZrO$_2$) und Siliziumdioxid (SiO$_2$) gebildet ist,und/oder, wobei ein Material der zweiten Schutzschicht (202) ein transparentes Harz, Siliziumdioxid oder Photoresist ist.

11. Touchpanel (20) nach Anspruch 1, wobei die Sensorschicht (130) eine Vielzahl von ersten Elektrodenblöcken (131) umfasst, die entlang einer ersten Richtung angeordnet sind, eine Vielzahl von ersten Drähten (132), die die benachbarten ersten Elektrodenblöcke (131) miteinander verbinden, eine Vielzahl von zweiten Elektrodenblöcken (133), die entlang einer zweiten Richtung angeordnet sind, eine Vielzahl von zweiten Drähten (134), die die benachbarten zweiten Elektrodenblöcke (133) miteinander verbinden, und eine Vielzahl von isolierenden Blöcken (135), die zwischen den ersten Drähten (132) und den zweiten Drähten (134) angeordnet sind, um die ersten Drähte (132) und die zweiten Drähte (134) elektrisch zu isolieren, wobei die zweiten Elektrodenblöcke (133) auf zwei Seiten der ersten Drähte (132) verteilt sind, wobei das Touchpanel (20) vorzugsweise weiterhin Folgendes umfasst: eine Maskenschicht (180), die sich auf mindestens einer Seite der Deckplatte (170) befindet, wobei die Sensorschicht (130) ferner eine Vielzahl von Signalleitungen (136) umfasst, die jeweils elektrisch mit den ersten Elektrodenblöcken (131) und den zweiten Elektrodenblöcken (133) verbunden sind, und die Maskenschicht (180) zur Abschirmung der Signalleitungen (136) verwendet wird.

12. Touchpanel (20) nach Anspruch 1, wobei ein Wärmeausdehnungskoeffizient der Pufferschicht (122) in einem Bereich zwischen einem Wärmeausdehnungskoeffizienten der Dünnfilmschicht (121) und einem Wärmeausdehnungskoeffizienten der Sensorschicht (130) liegt.

13. Touchpanel (20) nach Anspruch 1, wobei die Dünnfilmschicht (121) auf einem ersten Substrat (100) durch Aushärten nach Lösungsbeschichtung gebildet wird, wobei die Lösung vorzugsweise lösliches Polyimid und organische Lösungsmittel umfasst oder die Lösung Polyamidsäure und organische Lösungsmittel umfasst.

14. Das Touchpanel (20) nach Anspruch 1, wobei die Deckplatte (170) ein gehärtetes Glas ist.

## Revendications

1. Panneau tactile (20), comprenant :

   une plaque de recouvrement (170) ;
   une couche de liaison (160) ;
   une couche de film mince (121), dans lequel la couche de liaison (160) est située entre la plaque de recouvrement (170) et la couche de film mince (121) ;
   une couche tampon (122) située sur la couche de film mine, et la couche de film mince (121) située entre la couche de liaison (160) et la couche tampon (122) ; et
   une couche de détection (130) située sur la couche tampon (122), et la couche tampon (122) située entre la couche de détection (130) et la couche de film mince (121), dans lequel ledit panneau tactile (20) comprend en outre une couche de protection (200) sur la couche de détection (130), et la couche de détection (130) est située entre la couche tampon (122) et la couche de protection (200), dans lequel ladite couche de protection (200) est adaptée pour réduire l'érosion ou la corrosion de la couche de détection (130) provoquée par l'air, la vapeur d'eau ou d'autres substances dans l'environnement, et dans lequel un dispositif d'affichage peut être collé sur la couche de protection de façon à former un dispositif à écran tactile de manière coopérative.

2. Panneau tactile (20) selon la revendication 1, dans lequel la couche de protection (200) comprend une première couche de protection (201) et une seconde couche de protection (202), et la première couche de protection (201) est située entre la couche de détection (130) et la seconde couche de protection (202).

3. Panneau tactile (20) selon la revendication 1, dans lequel une épaisseur de la couche de film mince (121) est de l'ordre de 0,1 micron à 15 microns, de préférence de l'ordre de 2 microns à 5 microns.

4. Panneau tactile (20) selon la revendication 1, dans lequel un matériau de la couche de film mince (121) comprend du polypropylène (PP), du polystyrène (PS), de l'acrylonitrile-butadiène-styrène (ABS), du polyéthylène téréphtalate (PET), du polychlorure de vinyle (PVC), du polycarbonate (PC), du polyéthylène (PE), du polyméthacrylate de méthyle(PMMA), du polytétrafluoroéthylène (PTFE) et des copolymères de cyclo-oléfines (COP et Arton), ou des combinaisons de ceux-ci.

5. Panneau tactile (20) selon la revendication 1, dans lequel un indice de réfraction de la couche tampon (122) est $n_1$, un indice de réfraction de la couche de détection (130) est $n_T$, et un indice de réfraction de la couche de film mince est $n_f$, et dans lequel $n_f < n_1 < n_T$.

6. Panneau tactile (20) selon la revendication 1, dans lequel une épaisseur de la couche tampon (122) est de l'ordre de 1 nanomètre (10 angström) à environ 300 nanomètres (3000 angström).

7. Panneau tactile (20) selon la revendication 1, dans lequel un matériau de la couche tampon (122) comprend un matériau organique et un matériau inorganique.

8. Panneau tactile (20) selon la revendication 1, dans lequel un matériau de la couche tampon (122) comprend du dioxyde de titane ($TiO_2$), du dioxyde de silicium ($SiO_2$), du dioxyde de zirconium ($ZrO_2$), ou des combinaison de ceux-ci, ou un matériau composite formé par un matériau organique, du dioxyde de titane ($TiO_2$) et du dioxyde de silicium ($SiO_2$), ou un matériau composite formé par un matériau organique, du dioxyde de zirconium ($ZrO_2$) et du dioxyde de silicium ($SiO_2$).

9. Panneau tactile (20) selon la revendication 2, dans lequel un indice de réfraction de la première couche de protection (201) est $n_2$, et un indice de réfraction de la seconde couche de protection (202) est $n_3$, et un indice de réfraction de la couche de détection (130) est $n_T$, et dans lequel $n_3 < n_2 < n_T$.

10. Panneau tactile (20) selon la revendication 2, dans lequel un matériau de la première couche de protection (201) comprend un matériau organique et un matériau inorganique, et/ou dans lequel un matériau de la première couche de protection (201) comprend du dioxyde de titane ($TiO_2$), du dioxyde de silicium ($SiO_2$), du dioxyde de zirconium ($ZrO_2$), ou des combinaisons de ceux-ci, ou un matériau composite formé par un matériau organique, du dioxyde de titane ($TiO_2$) et du dioxyde de silicium ($SiO_2$), ou un matériau composite formé par un matériau organique, du dioxyde de zirconium ($ZrO_2$) et du dioxyde de silicium ($SiO_2$), et/ou dans lequel un matériau de la seconde couche de protection (202) est une résine transparente, du dioxyde de silicium ou une résine photosensible.

11. Panneau tactile (20) selon la revendication 1, dans lequel la couche de détection (130) comprend une pluralité de premiers blocs d'électrodes (131) disposés dans une première direction, une pluralité de premiers fils (132) qui relient les premiers blocs d'électrodes (131) de manière adjacente les uns aux autres, une pluralité de seconds blocs d'électrodes (133) disposés dans une seconde direction, une pluralité de seconds fils (134) qui relient les seconds blocs d'électrodes (133) de manière adjacente les uns aux autres, et une pluralité de blocs isolants (135) situés entre les premiers fils (132) et les seconds fils (134) afin d'isoler électriquement les premiers fils (132) et les seconds fils (134), dans lequel les seconds blocs d'électrodes (133) sont répartis des deux côtés des premiers fils (132), dans lequel le panneau tactile (20) comprend en outre de préférence :

une couche de masque (180) située sur au moins un côté de la plaque de recouvrement (170), dans lequel la couche de détection (130) comprend en outre une pluralité de lignes de signaux (136) respectivement reliées électriquement aux premiers blocs d'électrodes (131) et aux seconds blocs d'électrodes (133), et la couche de masque (180) est utilisée pour blinder les lignes de signaux (136).

12. Panneau tactile (20) selon la revendication 1, dans lequel un coefficient de dilatation thermique de la couche tampon (122) est compris entre un coefficient de dilatation thermique de la couche de film mince (121) et un coefficient de dilatation thermique de la couche de détection (130).

13. Panneau tactile (20) selon la revendication 1, dans lequel la couche de film mince (121) est formée sur un premier substrat (100) par durcissement après application d'une solution, dans lequel la solution comprend de préférence un polyimide soluble et des solvants organiques, ou la solution comprend de l'acide polyamique et des solvants organiques.

14. Panneau tactile (20) selon la revendication 1, dans lequel la plaque de recouvrement (170) est un verre trempé.

Fig. 1A

Fig. 1B

Fig. 1C

Fig. 1D

Fig. 1E-1

Fig. 1E-2

Fig. 1F

Fig. 1G

10

170
180
160
120 { 121
122
180
130

Fig. 1H

N      M      N

150
140
200
120 { 122
121
110
130
100

Fig. 2A

20

170
180
160
120 { 121
122
200 { 201
202
180
130

Fig. 2B

Fig. 3A

30   30   30

150

140

200

130

120 { 122
      121

110

300

Fig. 3B

30   30   30

150

140

200

130

120 { 122
      121

310

Fig. 3C

24

Fig. 3D

Fig. 4

**EP 3 051 391 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2013147727 A1